# FASCICULE DE BREVET EUROPEEN

(11) **EP 4 060 386 B1**
(45) Date de publication et mention de la délivrance du brevet: **24.06.2026**
(21) Numéro de dépôt: 21163489.4
(22) Date de dépôt: 18.03.2021
(51) Int. Cl.: G02B 1/14, G02B 5/28, G04B 19/12, G04B 37/22, G04B 45/00

(54) **PIÈCE D'HABILLAGE D'HORLOGERIE OU DE BIJOUTERIE COMPRENANT UN REVÊTEMENT DE COULEUR INTERFÉRENTIELLE ET PROCÉDÉ DE FABRICATION DE LADITE PIÈCE**
VERKLEIDUNGSTEIL EINER UHR ODER EINES SCHMUCKSTÜCKS MIT EINER INTERFERENZFARBBESCHICHTUNG UND VERFAHREN ZUR HERSTELLUNG DIESES TEILS
TRIM PART FOR A TIMEPIECE OR JEWELLERY ITEM COMPRISING AN INTERFERENTIAL COLOUR COATING AND METHOD FOR MANUFACTURING SAID PART

(43) Date de publication de la demande: 21.09.2022
(73) Titulaire: Omega SA, 2502 Bienne (CH)
(72) Inventeur: BARBOS, Corina, 2300 La Chaux-de-Fonds (CH); JEANRENAUD, Frédéric, 2300 La Chaux-de-Fonds (CH); KISSLING, Gregory, 2520 La Neuveville (CH)
(74) Mandataire: ICB SA

(56) Documents cités:
- EP-A1- 3 339 983
- US-A1- 2010 209 698
- US-B2- 6 849 343

## Description

### Domaine technique de l'invention

L'invention relève du domaine de l'horlogerie ou de la bijouterie, et concerne plus particulièrement une pièce d'habillage d'horlogerie ou de bijouterie comprenant un revêtement donnant une couleur interférentielle, et un procédé de fabrication de ladite pièce.

On désigne dans le présent texte par « pièces d'habillages », tout article décoratif dans les domaines de l'horlogerie ou de la bijouterie, par exemple constitué par un boitier, un cadran, une applique de cadran, un bracelet, etc. destiné à être visible pour un utilisateur.

Préférentiellement, la présente invention concerne une pièce d'habillage d'horlogerie ou de bijouterie comprenant un revêtement dont la couleur interférentielle est une nuance de rouge.

### Arrière-plan technologique

Dans le domaine de l'horlogerie ou de la bijouterie, et plus généralement dans celui des articles décoratifs, les procédés de dépôts par peinture, vernissage ou émaillage ne sont pas toujours adaptés.

En effet, d'une part, la couche de matière appliquée à la surface d'un article à décorer est trop épaisse pour laisser apparaitre d'éventuelles structurations de surface, par exemple une surface brossée, soleillée, sablée, structurée laser, etc., et d'autre part, la durée de vie de cette couche et par conséquent de sa couleur n'est pas toujours satisfaisante.

Ainsi, les techniques de dépôt de couches minces sous vide, tels que les procédés de dépôt physique en phase vapeur (connu sous l'acronyme en langue anglaise « PVD » pour « Physical Vapor Deposition »), les procédés de dépôt chimique en phase vapeur (connu sous l'acronyme en langue anglaise « CVD » pour « Chemical Vapor Deposition »), les procédés de dépôt de couche atomique (connu sous l'acronyme en langue anglaise « ALD » pour Atomic Layer Deposition), sont préférées.

Ces techniques de dépôt de couches minces sont décrites dans les documents EP3339983, US20100209698 et US6849343.

Toutefois, malgré le fait que ces techniques de dépôt permettent d'obtenir des revêtements d'une multitude de couleurs, la mise en œuvre de ces procédés ne permet pas d'obtenir de manière industrielle certaines couleurs spécifiques, telles que les nuances de rouge.

### Résumé de l'invention

L'invention résout les inconvénients précités en proposant une solution permettant de réaliser une pièce d'habillage présentant une couleur interférentielle prédéterminée résultant d'une addition d'interférences destructives et d'interférences constructives. On appelle dans le présent texte « couleur interférentielle » une couleur générée par un phénomène optique d'interférence.

A cet effet, la présente invention concerne une pièce d'habillage comprenant un substrat comportant un revêtement composé des couches suivantes successivement superposées :
- une couche réfléchissante opaque ou semi-opaque, configurée pour avoir une réflectance d'au minimum 90% pour les longueurs d'ondes comprises entre 600 nm et 780 nm, présentant une épaisseur d'au moins 40 nm,
- une couche transparente ou semi transparente, présentant un indice de réfraction compris entre 1.45 et 2.8 pour une longueur d'onde de 630 nm, et présentant une épaisseur comprise entre 10 nm et 50 nm,
- une couche absorbante présentant une épaisseur comprise entre 5 nm et 8 nm,
- une couche de protection acrylique et/ou nitrocellulosique superposée à la couche absorbante et présentant un indice de réfraction entre 1.48 et 1.51 pour une longueur d'onde de 630 nm.

Lesdites couches confèrent au revêtement une couleur interférentielle prédéterminée. En particulier, lesdites couches conférent au revêtement une couleur interférentielle rouge caractérisée dans l'espace chromatique CIELAB, illuminant D65, par un paramètre L* compris entre 25 et 35, un paramètre a* compris entre 8 et 15, et un paramètre b* compris entre 0 et 7.

Avantageusement, la couleur prédéterminée est une nuance de rouge présentant un éclat métallique. Plus spécifiquement, la couleur prédéterminée est une nuance de rouge bordeaux ou de rouge pourpre. Cette couleur prédéterminée est obtenue grâce à l'arrangement particulier de l'empilement optique défini par les couches du revêtement.

En outre, le revêtement présente une très faible épaisseur, typiquement inférieure à 3 µm, ce qui permet d'être adapté à recouvrir tout article décoratif comprenant une structuration de surface ou comprenant une forme géométrique complexe.

Un autre avantage de la présente invention réside dans le fait qu'elle permet d'obtenir une très grande variété de nuances de rouge sans modification substantielle de l'épaisseur du revêtement. A titre d'exemple l'épaisseur du revêtement varie au maximum d'une valeur inférieure à 3 nm entre l'ensemble des nuances de rouge que ledit revêtement peut présenter.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, la couche réfléchissante est réalisée en matériau métallique choisi parmi le cuivre (Cu), l'or (Au), le rhodium (Rh), le platine (Pt).

Dans des modes particuliers de réalisation, la couche réfléchissante est réalisée en Cu.

Dans des modes particuliers de réalisation, la couche réfléchissante présente une épaisseur de 100 nm.

Dans des modes particuliers de réalisation, la couche transparente est réalisée dans un matériau choisi parmi le dioxyde de silicium (SiO2), le dioxyde de titane (TiO2), l'alumine (Al2O3), le dioxyde d'hafnium (HfO2), le dioxyde de zirconium (ZrO2), l'oxyde de tantale (Ta2O5), le dioxyde d'étain (SnO2), l'oxyde d'indium-étain (ITO), l'oxyde de zinc (ZnO), l'oxyde de magnésium (MgO), le nitrure de silicium (Si3N4) et le nitrure d'aluminium (AIN).

Dans des modes particuliers de réalisation, la couche transparente est réalisée en SiO2.

Dans des modes particuliers de réalisation, la couche transparente présente une épaisseur de 30 nm.

Dans des modes particuliers de réalisation, la couche absorbante est réalisée dans un matériau choisi parmi : le titane (Ti), le nickel (Ni) ou le chrome (Cr).

Dans des modes particuliers de réalisation, la couche absorbante est réalisée en Cr.

Dans des modes particuliers de réalisation, le revêtement présente un taux de réflexion inférieur à 10% pour des longueurs d'onde comprises entre 350 nm et 600 nm, et supérieur ou égal à 10% pour des longueurs d'onde comprises entre 620 nm et 780 nm.

Selon un autre objet, la présente invention concerne un procédé de fabrication d'une pièce d'habillage d'horlogerie ou de bijouterie caractérisé en ce qu'il comprend les étapes successives suivantes de génération d'un revêtement sur une surface d'un substrat:
- dépôt d'une couche réfléchissante opaque sur un substrat, ladite couche étant configurée pour avoir une réflectance d'au minimum 90% pour les longueurs d'ondes comprises entre 600 nm et 780 nm, et présentant une épaisseur d'au moins 40 nm,
- dépôt d'une couche transparente présentant un indice de réfraction compris entre 1.45 et 2.8 à 630 nm, et présentant une épaisseur comprise entre 10 nm et 50 nm,
   - dépôt d'une couche absorbante présentant une épaisseur comprise entre 5 nm et 8 nm,

Le procédé comprend en outre une étape finale 104 de dépôt d'une couche de protection configurée pour comporter avantageusement un indice de réfraction compris entre 1.48 et 1.51 pour une longueur d'onde égale à 630 nm. Lesdites couches sont déposées de sorte à conférer au revêtement une couleur interférentielle rouge caractérisée dans l'espace chromatique CIELAB, illuminant D65, par un paramètre L* compris entre 25 et 35, un paramètre a* compris entre 8 et 15, et un paramètre b* compris entre 0 et 7.

Dans des modes particuliers de mise en œuvre, le dépôt des couches réfléchissante, transparente et absorbante est réalisé par procédé de dépôt physique en phase vapeur d'évaporation par canon à électrons.

Dans des modes particuliers de mise en œuvre, l'étape de dépôt de la couche transparente est réalisée avec une vitesse de dépôt comprise entre 0.01 nm/s et 0.1 nm/s.

Dans des modes particuliers de mise en œuvre, l'étape de dépôt de la couche absorbante est réalisée avec une vitesse de dépôt comprise entre 0.01 nm/s et 0.05 nm/s.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- la figure 1 représente schématiquement une vue de section d'une pièce d'habillage selon un exemple préféré de réalisation de l'invention ;
- la figure 2 représente une courbe de réflectance spectrale mesurées avec un spectrocolorimètre sur un revêtement selon l'invention ;
- la figure 3 représente une courbe de réflectance spectrale mesurées avec un spectrocolorimètre sur un revêtement selon l'invention comprenant en outre une couche de protection ;
- la figure 4 représente un logigramme d'un procédé de fabrication d'une pièce d'habillage selon un autre aspect de l'invention.

### Description détaillée de l'invention

La présente invention concerne une pièce d'habillage 10 comprenant un substrat 11 comportant un revêtement 12 composé de plusieurs couches successivement superposées permettant de conférer à la pièce d'habillage, sur une surface destinée à être visible pour un utilisateur une couleur interférentielle prédéterminée.

Préférentiellement, la couleur interférentielle prédéterminée est une nuance de rouge.

Le substrat 11 peut être réalisé dans un matériau métallique, céramique ou polymère. Par ailleurs, il peut être revêtu d'une sous couche galvanique.

Sur le substrat 11 est déposée une couche réfléchissante 121, opaque ou semi-opaque, configurée pour réfléchir des longueurs d'ondes comprises entre 600 nm et 780 nm.

Plus précisément, la couche réfléchissante 121 présente préférentiellement un coefficient de réflexion supérieur à 0.9 pour les longueurs d'ondes comprises entre 600 nm et 780 nm.

La couche réfléchissante 121 peut être semi-opaque dans le sens où elle peut avoir une transmittance différente de zéro, toutefois, la transmittance doit rester inférieure ou égale à 15% sur la gamme des longueurs d'onde du spectre visible.

Cette couche réfléchissante 121 est préférentiellement réalisée en matériau métallique et présente une épaisseur d'au moins 40 nm.

Préférentiellement, la couche réfléchissante 121 est réalisée dans un matériau qui est choisi parmi : Cu, Au, Rh ou Pt. Le matériau de la couche réfléchissante 121 est choisi pour sa capacité optique à réfléchir les longueurs d'ondes comprises entre 600 nm et 780 nm, cet intervalle étant représentatif de nuances de rouge du spectre lumineux. En outre, ce matériau est choisi pour sa faible absorption des longueurs d'onde dans le rouge.

Plus préférentiellement encore, la couche réfléchissante 121 est réalisée en Cu, notamment pour des raisons économiques et de facilité de mise en œuvre.

La couche réfléchissante 121 peut être réalisée par procédé PVD, par galvanisation ou par tout autre procédé approprié de dépôt de couche mince.

Une couche transparente 122 est superposée à la couche réfléchissante 121.

La couche transparente 122 peut également être semitransparente dans le sens où elle peut absorber la lumière sur une certaine plage de longueurs d'onde, par exemple les longueurs d'ondes inférieures à 500 nm dans le cas où ladite couche transparente 122 serait réalisée en TiO2, et être transparente pour la lumière sur une autre plage de longueurs d'onde.

Le matériau de cette couche transparente 122 est choisi pour ses propriété optiques de transparence. A titre d'exemple, la couche transparente 122 est réalisée dans un matériau choisi parmi : SiO2, TiO2, Al2O3, HfO2, ZrO2, Ta2O5, SnO2, ITO, ZnO, MgO, Si3N4, AIN. Préférentiellement, la couche transparente 122 est réalisée en SiO2, notamment pour des raisons économiques, de facilité de mise en œuvre et de répétabilité.

Par exemple, la couche transparente 122 présente avantageusement un indice de réfraction compris entre 1.45 et 2.8 pour une longueur d'onde de 630 nm et présente une épaisseur comprise entre 10 nm et 50 nm, selon l'indice de réfraction de cette dernière.

La couche transparente 122 peut être déposée sur la couche réfléchissante 121 par procédé PVD, CVD, ALD, ou par tout autre procédé approprié de dépôt de couche mince.

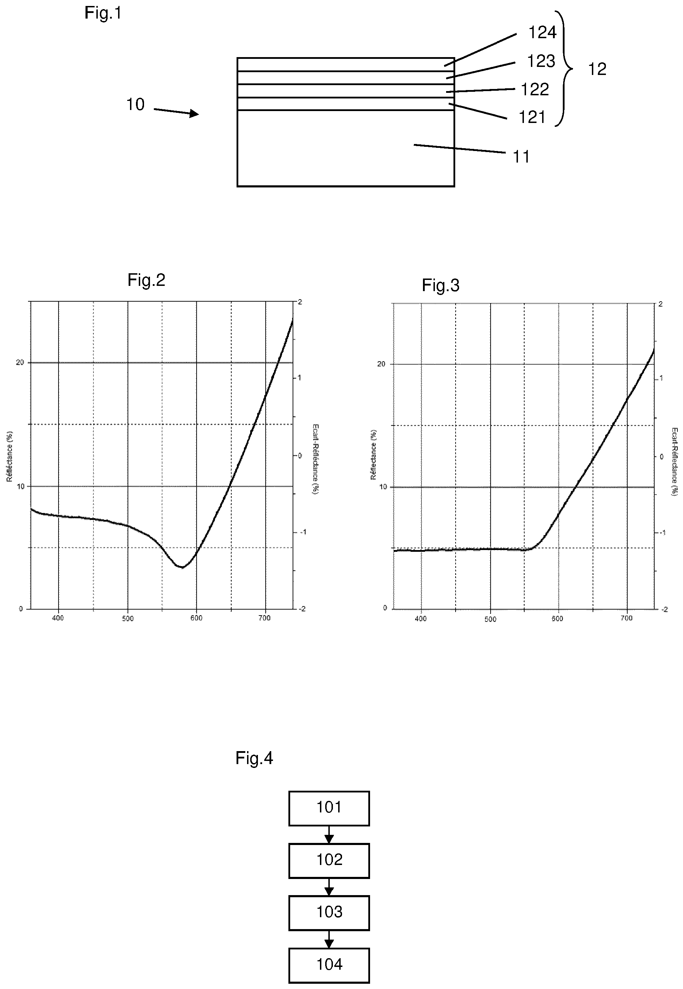

Enfin, comme le montre la figure 1, une couche absorbante est superposée à la couche transparente 122.

Cette couche absorbante 123 est réalisée dans un matériau métallique, choisi pour ses propriétés optiques d'absorption. A titre d'exemple, la couche absorbante 123 est réalisée en Ti, Ni ou Cr. Préférentiellement, la couche absorbante 123 est réalisée en chrome.

La couche absorbante 123 présente une épaisseur comprise entre 4 nm et 10 nm, préférentiellement entre 5 nm et 8 nm, et encore plus préférentiellement entre 7.2 nm et 7.8 nm.

On comprend ici que la présente invention permet, grâce au revêtement 12, d'obtenir avantageusement une couleur interférentielle en nuance de rouge, ledit revêtement 12 présentant une épaisseur très faible, de l'ordre de quelques millièmes de millimètres, plus précisément inférieur à 3 µm.

Le revêtement 12 est avantageusement configuré, grâce aux caractéristiques précitées, de sorte à présenter un taux de réflexion inférieur à 10%, évoluant de 8% à 3%, pour des longueurs d'ondes comprises entre 350 nm et 580 nm, et évoluant de 3% à 24% pour des longueurs d'ondes comprises entre 580 nm et 750 nm. Ces valeurs sont représentées graphiquement par la courbe de réflectance spectrale de la figure 2, issue de mesures réalisées avec un spectrocolorimètre sur le revêtement 12.

Ces taux de réflexion peuvent avantageusement définir un spectre de réflexion représentatif d'une perception visuelle d'un utilisateur d'une couleur comprise dans une nuance de rouge.

Le revêtement 12 comporte en outre avantageusement une couche de protection 124, acrylique et/ou nitrocellulosique, superposée à la couche absorbante 123, afin de protéger les autres couches d'éventuelles agressions chimiques et/ou mécaniques.

L'ajout d'une telle couche de protection 124, par exemple d'une épaisseur de 3 µm d'un indice de réfraction proche de 1.5, par exemple entre 1.48 et 1.51 pour les longueurs d'onde de 630 nm, permet également aussi de générer des interférences destructives qui diminuant avantageusement le taux de réflexion entre 350 nm et 550 nm laissant les longueurs d'ondes entre 580 nm et 780 nm définir la couleur du revêtement 12.

Autrement dit, la couche de protection 124 participe avantageusement à l'obtention de la couleur rouge finale du revêtement 12.

Avec la couche de protection 124, le revêtement 12 présente un taux de réflexion inférieur ou égale à 5% dans la gamme de longueurs d'ondes comprise entre 350 nm et 550 nm, évoluant de 5 à 21% pour des longueurs d'ondes comprises entre 550 nm et 750 nm. Ces valeurs sont représentées graphiquement par la courbe de réflectance spectrale de la figure 3, issue de mesures réalisées avec un spectrocolorimètre sur le revêtement 12.

Ainsi, le revêtement 12 présente une couleur rouge caractérisée dans l'espace chromatique CIELAB, illuminant D65, par un paramètre L* compris entre 25 et 35, un paramètre a* compris entre 8 et 15, et un paramètre b* compris entre 0 et 7.

La présente invention concerne en outre un procédé de fabrication d'une pièce d'habillage 10 d'horlogerie ou de bijouterie, par exemple telle que décrite ci-avant. Les étapes successives de ce procédé sont représentées par le logigramme de la figure 4 et consistent en la génération d'un revêtement 12 sur une surface d'un substrat 11 afin de générer une couleur interférentielle prédéterminée.

Plus spécifiquement, le procédé comprend les étapes successives suivantes :
- dépôt 101 d'une couche réfléchissante 121 opaque sur un substrat 11, ladite couche étant adaptée à réfléchir les longueurs d'ondes comprises entre 600 nm et 780 nm,
- dépôt 102 d'une couche transparente 122 présentant un indice de réfraction compris entre 1.45 et 2.8 pour une longueur d'onde de 630 nm,
- dépôt 103 d'une couche absorbante 123.

Un exemple de procédé de fabrication décrit en détail par la suite utilise une technique de dépôt sous vide pour déposer les couches réfléchissante 121, transparente 122 et absorbante 123.

Plus particulièrement, dans un mode de mise en œuvre préféré, un procédé de dépôt physique en phase vapeur d'évaporation par canon à électrons est utilisé.

Toutefois, il y a lieu de noter que le dépôt des couches peut être réalisé par d'autres méthodes PVD, comme la pulvérisation magnétron en milieux réactif, ou par procédé CVD, comme le procédé ALD et le dépôt chimique en phase vapeur assisté par plasma (connu sous l'acronyme de langue anglaise PECVD pour « Plasma Enhanced Chemical Vapor Deposition »).

Le dépôt 101 de la couche réfléchissante 121 est réalisé, par exemple de sorte que ladite couche réfléchissante 121 présente une épaisseur de 100 nm. Préférentiellement, parmi les matériaux suivants envisageables pour constituer la couche réfléchissante 121 : Cu, Au, Rh ou Pt, le Cu est privilégié.

La couche transparente 122 est ensuite déposée sur la couche réfléchissante 121, préférentiellement de sorte à présenter une épaisseur de 30 nm. Préférentiellement, parmi les matériaux suivants envisageables pour constituer la couche transparente 122 : SiO2, TiO2, Al2O3, HfO2, ZrO2, Ta2O5, SnO2, ITO, ZnO, MgO, Si3N4, ou l'AIN, le SiO2 est privilégié.

A titre d'exemple, afin d'obtenir une bonne répétabilité pour le dépôt de la couche transparente 122, la vitesse de dépôt est choisie entre 0.01 nm/s et 0.1 nm/s, préférentiellement 0.1 nm/s, et le flux de dioxygène (O2) est de 5 sccm. Ces paramètres permettent en outre d'obtenir un contrôle très précis de la densité de matière et de l'épaisseur de la couche transparente 122.

La couche absorbante 123 est ensuite déposée sur la couche transparente 122, préférentiellement de sorte à présenter une épaisseur comprise par exemple entre 5 nm et 8 nm, préférentiellement entre 7.2 nm et 7.8 nm. Préférentiellement, la couche absorbante 123 est réalisée en chrome.

A titre d'exemple, afin d'obtenir une bonne répétabilité pour le dépôt de la couche absorbante 123, la vitesse de dépôt est choisie entre 0.01 nm/s et 0.05 nm/s, préférentiellement 0.02 nm/s, et le flux d'argon (Ar) est de 2 sccm de sorte à minimiser l'influence de l'encrassement des parois de l'enceinte sur la répétabilité du dépôt de la couche absorbante 123.

Le procédé de fabrication comporte également une étape finale 104 de dépôt d'une couche de protection 124. Cette couche de protection 124 est configurée pour comporter avantageusement un indice de réfraction d'environ compris entre 1.48 et 1.51 pour une longueur d'onde de 630 nm.

## Revendications

1. Pièce d'habillage (10) d'horlogerie ou de bijouterie comprenant un substrat (11) comportant un revêtement (12) composé des couches suivantes successivement superposées :
- une couche réfléchissante (121) opaque ou semi-opaque, configurée pour avoir une réflectance d'au minimum 90% pour les longueurs d'ondes comprises entre 600 nm et 780 nm, présentant une épaisseur d'au moins 40 nm,
- une couche transparente (122) ou semi transparente, présentant un indice de réfraction compris entre 1.45 et 2.8 pour une longueur d'onde de 630 nm, et présentant une épaisseur comprise entre 10 nm et 50 nm,
- une couche absorbante (123) présentant une épaisseur comprise entre 5 nm et 8 nm,
- une couche de protection acrylique et/ou nitrocellulosique (124) superposée à la couche absorbante (123) et présentant un indice de réfraction entre 1.48 et 1.51 pour une longueur d'onde de 630 nm,
lesdites couches conférant au revêtement (12) une couleur interférentielle rouge caractérisée dans l'espace chromatique CIELAB, illuminant D65, par un paramètre L* compris entre 25 et 35, un paramètre a* compris entre 8 et 15, et un paramètre b* compris entre 0 et 7.

2. Pièce d'habillage (10) selon la revendication 1, dans laquelle la couche réfléchissante (121) est réalisée en matériau métallique choisi parmi : Cu, Au, Rh, Pt.

3. Pièce d'habillage (10) selon la revendication 1 ou 2, dans laquelle la couche réfléchissante (121) est réalisée en Cu.

4. Pièce d'habillage (10) selon l'une des revendications 1 à 3, dans laquelle la couche réfléchissante (121) présente une épaisseur de 100 nm.

5. Pièce d'habillage (10) selon l'une des revendications 1 à 4, dans laquelle la couche transparente (122) est réalisée dans un matériau choisi parmi : SiO2, TiO2, Al2O3, HfO2, ZrO2, Ta2O5, SnO2, ITO, ZnO, MgO, Si3N4, AIN.

6. Pièce d'habillage (10) selon la revendication 5, dans laquelle la couche transparente (122) est réalisée en SiO2.

7. Pièce d'habillage (10) selon l'une des revendications 1 à 6, dans laquelle la couche transparente (122) présente une épaisseur de 30 nm.

8. Pièce d'habillage (10) selon l'une des revendications 1 à 7, dans laquelle la couche absorbante (123) est réalisée dans un matériau choisi parmi : Ti, Ni ou Cr.

9. Pièce d'habillage (10) selon la revendication 8, dans laquelle la couche absorbante (123) est réalisée en Cr.

10. Pièce d'habillage (10) selon l'une des revendications 1 à 9, dans lequel le revêtement (12) présente un taux de réflexion inférieur à 10% pour des longueurs d'onde comprises entre 350 nm et 600 nm, et supérieur ou égal à 10% pour des longueurs d'onde comprises entre 620 nm et 780 nm.

11. Procédé de fabrication d'une pièce d'habillage (10) d'horlogerie ou de bijouterie, ledit procédé comprenant les étapes successives suivantes de génération d'un revêtement (12) sur une surface d'un substrat (11):
- dépôt 101 d'une couche réfléchissante (121) opaque sur un substrat (11), ladite couche étant configurée pour avoir une réflectance supérieure à 90% pour les longueurs d'ondes comprises entre 600 nm et 780 nm et présentant une épaisseur d'au moins 40 nm,
- dépôt 102 d'une couche transparente (122) présentant un indice de réfraction compris entre 1.45 et 2.8 pour une longueur d'onde de 630 nm, et présentant une épaisseur comprise entre 10 nm et 50 nm,
- dépôt 103 d'une couche absorbante (123) présentant une épaisseur comprise entre 5 nm et 8 nm,
le procédé comprenant en outre une étape finale 104 de dépôt d'une couche de protection (124) configurée pour comporter avantageusement un indice de réfraction compris entre 1.48 et 1.51 pour une longueur d'onde égale à 630 nm, lesdites couches étant déposées de sorte à conférer au revêtement (12) une couleur interférentielle rouge caractérisée dans l'espace chromatique CIELAB, illuminant D65, par un paramètre L* compris entre 25 et 35, un paramètre a* compris entre 8 et 15, et un paramètre b* compris entre 0 et 7.

12. Procédé de fabrication selon la revendication 11, dans lequel le dépôt 101, 102 et 103 respectivement des couches réfléchissante (121), transparente (122) et absorbante (123) est réalisé par procédé de dépôt physique en phase vapeur d'évaporation par canon à électrons.

13. Procédé de fabrication selon l'une des revendications 11 ou 12 dans lequel l'étape de dépôt 102 de la couche transparente (122) est réalisée avec une vitesse de dépôt comprise entre 0.01 nm/s et 0.1 nm/s.

14. Procédé de fabrication selon l'une des revendications 11 à 13 dans lequel l'étape de dépôt 103 de la couche absorbante (123) est réalisée avec une vitesse de dépôt comprise entre 0.01 nm/s et 0.05 nm/s.

## Patentansprüche

1. Ausstattungsteil (10) der Uhrmacherei oder der Schmuckherstellung, umfassend ein Substrat (11) mit einer Beschichtung (12), die aus den folgenden nacheinander aufgebrachten Schichten besteht:
- einer reflektierenden (121) opaken oder semiopaken Schicht, konfiguriert für eine Reflektivität von mindestens 90 % für Wellenlängen zwischen 600 nm und 780 nm, mit einer Dicke von mindestens 40 nm,
- einer transparenten (122) oder halbtransparenten Schicht mit einem Brechungsindex zwischen 1,45 und 2,8 bei einer Wellenlänge von 630 nm und einer Dicke zwischen 10 nm und 50 nm,
- einer absorbierende Schicht (123) mit einer Dicke zwischen 5 nm und 8 nm,
- einer acrylischen und/oder nitrocellulosischen Schutzschicht (124), die über der absorbierenden Schicht (123) angeordnet ist und einen Brechungsindex zwischen 1,48 und 1,51 bei einer Wellenlänge von 630 nm aufweist,
wobei diese Schichten der Beschichtung (12) eine rote Interferenzfarbe verleihen, die im CIELAB-Farbraum, Lichtart D65, durch einen Parameter L* zwischen 25 und 35, einen Parameter a* zwischen 8 und 15 und einen Parameter b* zwischen 0 und 7 gekennzeichnet ist.

2. Ausstattungsteil (10) nach Anspruch 1, bei dem die reflektierende Schicht (121) aus einem metallischen Material besteht, ausgewählt aus: Cu, Au, Rh, Pt.

3. Ausstattungsteil (10) nach Anspruch 1 oder 2, wobei die reflektierende Schicht (121) aus Cu hergestellt ist.

4. Ausstattungsteil (10) nach einem der Ansprüche 1 bis 3, wobei die reflektierende Schicht (121) eine Dicke von 100 nm aufweist.

5. Ausstattungsteil (10) nach einem der Ansprüche 1 bis 4, wobei die transparente Schicht (122) aus einem Material besteht, ausgewählt aus: SiO2, TiO2, Al2O3, HfO2, ZrO2, Ta2O5, SnO2, ITO, ZnO, MgO, Si3N4, AlN.

6. Ausstattungsteil (10) nach Anspruch 5, wobei die transparente Schicht (122) aus SiO2 hergestellt ist.

7. Ausstattungsteil (10) nach einem der Ansprüche 1 bis 6, wobei die transparente Schicht (122) eine Dicke von 30 nm aufweist.

8. Ausstattungsteil (10) nach einem der Ansprüche 1 bis 7, wobei die absorbierende Schicht (123) aus einem Material besteht, ausgewählt aus: Ti, Ni oder Cr.

9. Ausstattungsteil (10) nach Anspruch 8, wobei die absorbierende Schicht (123) aus Cr hergestellt ist.

10. Ausstattungsteil (10) nach einem der Ansprüche 1 bis 9, wobei die Beschichtung (12) eine Reflexionsrate von unter 10 % bei Wellenlängen zwischen 350 nm und 600 nm und von größer oder gleich 10 % bei Wellenlängen zwischen 620 nm und 780 nm aufweist.

11. Verfahren zur Herstellung eines Ausstattungsteils (10) der Uhrmacherei oder der Schmuckherstellung, wobei das Verfahren die folgenden aufeinanderfolgenden Schritte zur Erzeugung einer Beschichtung (12) auf einer Oberfläche eines Substrats (11) umfasst:
- Abscheidung 101 einer opaken reflektierenden Schicht (121) auf einem Substrat (11), wobei diese Schicht so konfiguriert ist, dass sie für Wellenlängen zwischen 600 nm und 780 nm eine Reflektivität von über 90 % umfasst und eine Dicke von mindestens 40 nm aufweist,
- Abscheidung 102 einer transparenten Schicht (122) mit einem Brechungsindex zwischen 1,45 und 2,8 bei einer Wellenlänge von 630 nm und einer Dicke zwischen 10 nm und 50 nm,
- Abscheidung 103 einer absorbierenden Schicht (123) mit einer Dicke zwischen 5 nm und 8 nm,
wobei das Verfahren ferner einen abschließenden Schritt 104 der Abscheidung einer Schutzschicht (124) umfasst, die so ausgebildet ist, dass sie vorteilhafterweise einen Brechungsindex zwischen 1,48 und 1,51 für eine Wellenlänge von 630 nm aufweist, wobei diese Schichten so abgeschieden werden, dass sie der Beschichtung (12) eine rote Interferenzfarbe verleihen, die im CIELAB-Farbraum, Lichtart D65, durch einen Parameter L* zwischen 25 und 35, einen Parameter a* zwischen 8 und 15 und einen Parameter b* zwischen 0 und 7 gekennzeichnet ist.

12. Herstellungsverfahren nach Anspruch 11, wobei die Abscheidung 101, 102 und 103 der reflektierenden (121), transparenten (122) und absorbierenden (123) Schichten jeweils durch physikalische Gasphasenabscheidung mittels Elektronenstrahlverdampfung erfolgt.

13. Herstellungsverfahren nach einem der Ansprüche 11 oder 12, wobei der Abscheideschritt 102 der transparenten Schicht (122) mit einer Abscheiderate zwischen 0,01 nm/s und 0,1 nm/s durchgeführt wird.

14. Herstellungsverfahren nach einem der Ansprüche 11 bis 13, wobei der Abscheideschritt 103 der absorbierenden Schicht (123) mit einer Abscheiderate zwischen 0,01 nm/s und 0,05 nm/s durchgeführt wird.

## Claims

1. An external part (10) for horology or for jewellery comprising a substrate (11) comprising a plating (12) consisting of the following successively overlapping layers:
- an opaque or semi-opaque reflective layer (121), configured to have a reflectance of at least 90% for wavelengths comprised between 600 nm and 780 nm, with a thickness of at least 40 nm,
- a transparent or semi-transparent layer (122), with a refractive index comprised between 1.45 and 2.8 for a wavelength of 630 nm, and with a thickness comprised between 10 nm and 50 nm,
- an absorbent layer (123) with a thickness comprised between 5 nm and 8 nm,
- a protective layer (124) of acrylic and/or nitrocellulose that overlaps the absorbent layer (123) and has a refractive index between 1.48 and 1.51 for a wavelength of 630 nm,
said layers imparting to the plating (12) a red interference colour **characterised, in** the CIELAB colour space, illuminant D65, by an L* parameter comprised between 25 and 35, an a* parameter comprised between 8 and 15, and a b* parameter comprised between 0 and 7.

2. The external part (10) according to claim 1, in which the reflective layer (121) is made of a metallic material chosen among: Cu, Au, Rh, Pt.

3. The external part (10) according to claim 1 or 2, in which the reflective layer (121) is made of Cu.

4. The external part (10) according to any of claims 1 to 3, in which the reflective layer (121) has a thickness of 100 nm.

5. The external part (10) according to any of claims 1 to 4, in which the transparent layer (122) is made of a material chosen among: SiO2, TiO2, Al2O3, HfO2, ZrO2, Ta2O5, SnO2, ITO, ZnO, MgO, Si3N4, AlN.

6. The external part (10) according to claim 5, in which the transparent layer (122) is made of SiO2.

7. The external part (10) according to any of claims 1 to 6, in which the transparent layer (122) has a thickness of 30 nm.

8. The external part (10) according to any of claims 1 to 7, in which the absorbent layer (123) is made of a material chosen among: Ti, Ni or Cr.

9. The external part (10) according to claim 8, in which the absorbent layer (123) is made of Cr.

10. The external part (10) according to any of claims 1 to 9, in which the plating (12) has a reflectance of less than 10% for wavelengths comprised between 350 nm and 600 nm, and greater than or equal to 10% for wavelengths comprised between 620 nm and 780 nm.

11. A method for manufacturing an external part (10) for horology or for jewellery, said method comprising the following successive steps of hobbing a plating (12) on a surface of a substrate (11):
- depositing 101 an opaque reflective layer (121) onto a substrate (11), said layer being configured to have a reflectance greater than 90% for wavelengths comprised between 600 nm and 780 nm and with a thickness of at least 40 nm,
- depositing 102 a transparent layer (122), with a refractive index comprised between 1.45 and 2.8 for a wavelength of 630 nm, and with a thickness comprised between 10 nm and 50 nm,
- depositing 103 an absorbent layer (123) with a thickness comprised between 5 nm and 8 nm,
the method further comprising a final step 104 involving the deposition of a protective layer (124) configured to advantageously have a refractive index comprised between 1.48 and 1.51 for a wavelength equal to 630 nm, said layers being deposited so as to impart to the plating (12) a red interference colour **characterised in** the CIELAB colour space, illuminant D65, by an L* parameter comprised between 25 and 35, an a* parameter comprised between 8 and 15, and a b* parameter comprised between 0 and 7.

12. The manufacturing method according to claim 11, in which the reflective (121), transparent (122) and absorbent (123) layers 101, 102 and 103, respectively, are deposited using an electron beam physical vapour deposition method.

13. The manufacturing method according to any of claims 11 or 12, in which the transparent layer (122) deposition step 102 is carried out at a deposition velocity comprised between 0.01 nm/s and 0.1 nm/s.

14. The manufacturing method according to any of claims 11 or 13, in which the absorbent layer (123) deposition step 103 is carried out at a deposition velocity comprised between 0.01 nm/s and 0.05 nm/s.
